# EUROPEAN PATENT SPECIFICATION

(11) **EP 0 481 379 B1**
(45) Date of publication and mention of the grant of the patent: **05.02.1997**
(21) Application number: 91117410.0
(22) Date of filing: 11.10.1991
(51) Int. Cl.: H01L 29/772

(54) **Thin film transistor and manufacturing method thereof**
Dünnfilm-Transistor und Verfahren zur Herstellung
Transistor en couche mince et sa méthode de fabrication

(30) Priority: 12.10.1990 JP 274360/90; 30.08.1991 JP 220277/91
(43) Date of publication of application: 22.04.1992
(73) Proprietor: MITSUBISHI DENKI KABUSHIKI KAISHA, Tokyo (JP)
(72) Inventor: Tsutsumi, Kazuhito, c/o Mitsubishi Denki K. K. LSI, Itami-chi, Hyogo-ken (JP)
(74) Representative: Prüfer, Lutz H., Dipl.-Phys.

(56) References cited:
- EP-A- 0 102 802
- FR-A- 2 535 528
- PATENT ABSTRACTS OF JAPAN vol. 11, no. 70 (E-485)(2517) 3 March 1987 & JP-A-61 225 869
- PATENT ABSTRACTS OF JAPAN vol. 011, no. 231 (E-527)28 July 1987 & JP-A-62 048 045
- JAPANESE JOURNAL OF APPLIED PHYSICS EXTENDED ABSTRACTS 22TH. CONF. SOLID STATE DEVICES AND MATERIALS(1990), TOKYO, JAPAN pages 1195 - 1196; T. UEDA ET AL: 'A 5nm Thick Ultra-Thin Double-Gated Poly Si TFT Using Si2H6 as a Source Gas'
- PATENT ABSTRACTS OF JAPAN vol. 013, no. 550 (P-972)8 December 1989 & JP-A-1 229 229
- IEEE 1989 MICROWAVE AND MILLIMETER-WAVE MONOLITHIC CIRCUITS SYMPOSIUM DIGEST OF PAPERS LONG BEACH, CA JUNE 12-13, 1989 pages 21 - 24; INDER J. BAHL ET AL: 'C-BAND 10 WATT MMIC AMPLIFIER MANUFACTURED USING REFRACTORY SAG PROCESS'

## Description

The present invention relates to thin film transistors with increased gate dielectric breakdown voltage, and to a manufacturing method of the thin film transistors.

Insulated gate field effect transistors configured by forming a semiconductor thin film on an insulating substrate and providing a channel region in this film includes a so-called thin film transistor.

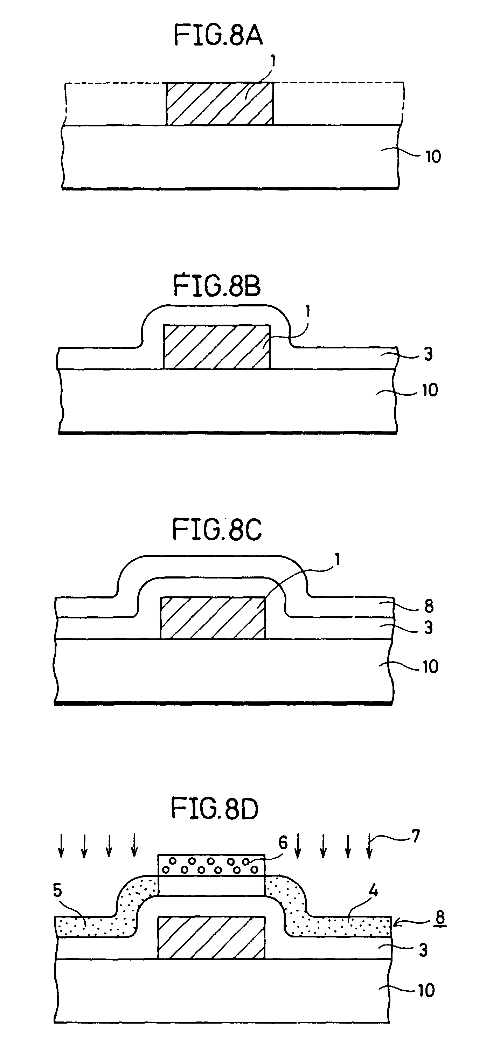

Fig. 7 is a diagram showing a sectional structure of a conventional thin film transistor. Referring to Fig. 7, in a conventional thin film transistor, a gate electrode 1 formed of polysilicon is formed on a surface of an insulating substrate or insulating layer 10. Furthermore, a dielectric layer 3 formed of an oxide film with a film thickness t of about 250Å, for example, is formed on the surfaces of insulating substrate 10 and gate electrode 1. Furthermore, a polysilicon layer with a film thickness of about 200Å is formed on the surface of dielectric layer 3. Conductive regions 4 and 5 to be a pair of source/drain regions are formed in polysilicon layer 8, wherein a region located between the conductive regions 4 and 5 configures a channel region 2.

Next, the process for manufacturing such a thin film transistor as described above will be described. Figs. 8A through 8D are manufacturing process sectional diagrams of the thin film transistor shown in Fig. 7.

First, as shown in Fig. 8A, after forming a polysilicon layer on the surface of insulating substrate 10, it is patterned to be a predetermined shape employing the photolithography method and the etching method. Gate electrode 1 is formed in this process.

Next, as shown in Fig. 8B, applying the low pressure CVD (Chemical Vapor Deposition) method all over the surface, an oxide film is deposited to a film thickness of about 250Å, for example. The oxide film serves as dielectric layer 3.

Furthermore, as shown in Fig. 8C, a polysilicon layer 8 is formed on the surface of dielectric layer 3 to a film thickness of about 200Å using the low pressure CVD method. Then, using the photography method and the etching method, polysilicon layer 8 is patterned into a predetermined shape.

Subsequently, as shown in Fig. 8D, a resist pattern 6 is formed at a predetermined position on the surface of polysilicon layer 8. Then, using the resist pattern 6 as a mask, p-type impurity, e.g., BF₂ ions 7 are implanted into polysilicon layer 8 to form p-type conductive regions 4 and 5 in polysilicon layer 8.

By the above-described process, the thin film transistor shown in Fig. 7 is formed.

A thin film transistor manufactured by the above manufacturing method has a problem that the film thickness of dielectric film 3 is uneven especially above a corner of gate electrode 1, so that a strong electric field is produced in this region in a predetermined operation. That is, in dielectric film 3 formed by the CVD method, the film thickness is decreased at the corner of gate electrode 1 as compared to other portions. Accordingly, in the vicinity of this region, an effective film thickness necessary for securing a predetermined dielectric breakdown voltage decreases.

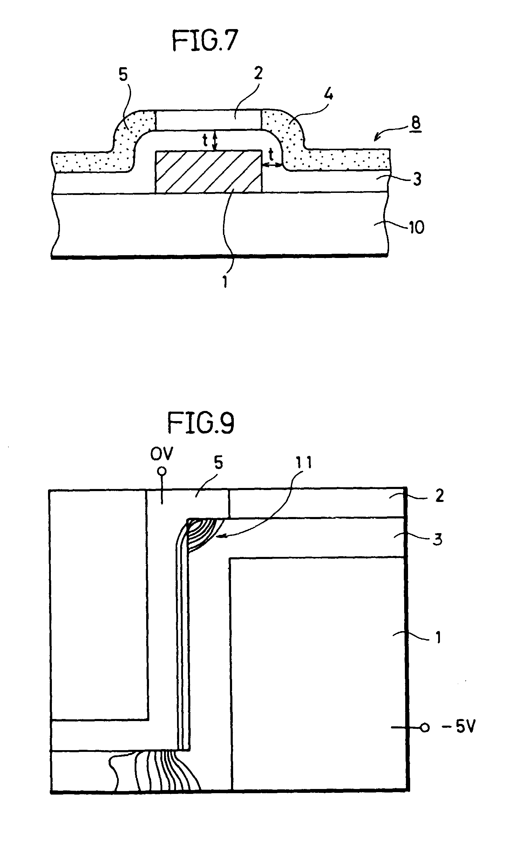

Fig. 9 is an electric field distribution diagram showing electric field distribution in the vicinity of a corner of gate electrode. In the condition shown in the figure, -5V is applied to gate electrode 1, 0V is applied to a source region, and -5V is applied to the drain region. In this simulation, a dielectric film 3 is modeled in a shape having a uniform film thickness and having a corner corresponding to a corner of gate electrode 1. As shown in Fig. 9, it is known that the gradient of the equal electric field curves 11 become sharp in a corner of dielectric layer 3 located above a corner of gate electrode 1 to produce electric field concentration. Such a strong electric field region causes leakage from gate electrode 1 to source/drain regions 4 and 5 to decrease the driving current of the thin film transistor. Also, in some cases, the strong electric field concentration produces dielectric breakdown of the dielectric film.

JP-A-61-225 869 discloses a thin film transistor as is specified in the preamble of claim 1. In particular, a gate insulating film covers the underlying insulating layer and the gate electrode as a integral layer. A semiconductor thin film is provided on the gate insulating film. On the semiconductor thin film wiring electrodes for drain and source are provided with the conductive films there between.

Japanese J. of Applied Physics, Extended Abstracts of the 22nd Conf. on Solid State Device and Materials, Sendai, 1990, pp. 1195-1196, discloses a thin film transistor wherein the side walls of the gate electrodes are covered with side wall spacers. The thin film transistor comprises a double-gated structure.

IEEE 1989 Microwave and Millimeter-Wave Monolithic Circuits Symp., Long Beach, CA, pp. 21-24 discloses a manufacturing method for multifunctional self-aligned gate structures. A gate is covered by Si ON. A planarization with reflowed resist takes place. The device is etched back until the gate is exposed.

It is an object of the present invention to provide a thin film transistor having a gate structure capable of moderating electric field concentration inside a dielectric layer which can be manufactured easily and to provide a manufacturing method for manufacturing a thin film transistor having a large gate dielectric breakdown voltage.

This object is solved by a thin film transistor having the features of claim 1 and by a method having the features of claim 3. A preferred thin film transistor is given in claim 2.

Forming a dielectric layer having its film thickness thicker in a portion in contact with an angular portion and a sidewall portion of a gate electrode moderates the electric field concentration in the region in the vicinity of the angular portion of the gate electrode to prevent the degradation of a dielectric breakdown voltage, and the dielectric breakdown.

The foregoing and other objects, features, aspects and advantages of the present invention will become more apparent from the following detailed description of the present invention when taken in conjunction with the accompanying drawings.

Fig. 1 is a sectional structure diagram of a thin film transistor in accordance with the present invention.

Figs. 2A, 2B, 2C, 2D, 2E and 2F are sectional diagrams showing steps of manufacturing a thin film transistor shown in Fig. 1.

Figs. 3A, 3B, 3C, 3D and 3E are sectional diagrams showing another process of manufacturing a thin film transistor.

Fig. 4 is a sectional structural view of another thin film transistor.

Figs. 5A, 5B, 5C, 5D and 5E are sectional diagrams showing a process of manufacturing the thin film transistor shown in Fig. 4.

Fig. 6 is an electrical field strength distribution diagram showing the electric field strength distribution when the thin film transistor shown in Fig. 1 is operating.

Fig. 7 is a sectional structure diagram of a conventional thin film transistor.

Figs. 8A, 8B, 8C and 8D are sectional diagrams showing a process for manufacturing the conventional thin film transistor shown in Fig. 7.

Fig. 9 is an electric field strength distribution diagram showing the electric field strength distribution of a conventional thin film transistor.

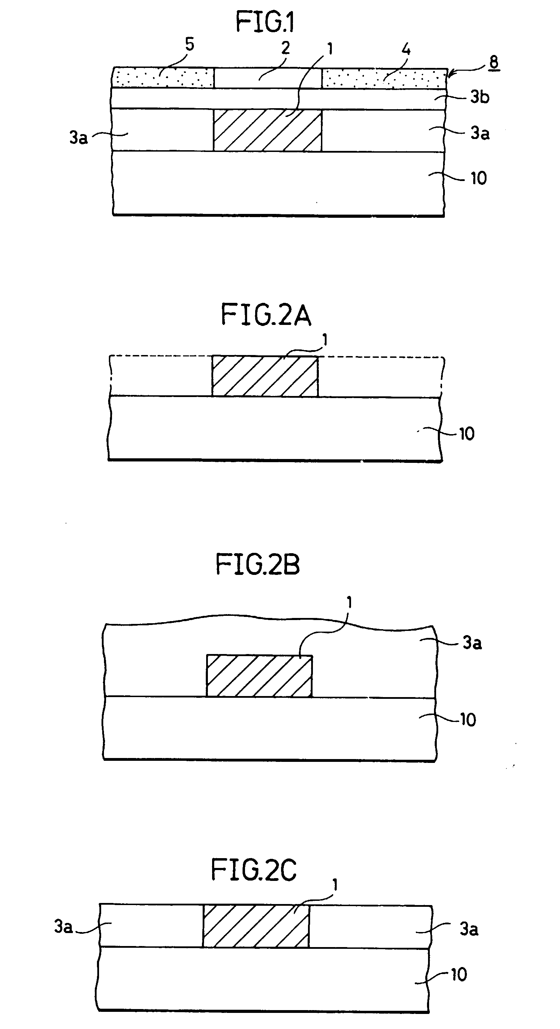

Referring to Fig. 1, a thin film transistor in accordance with the first embodiment of the present invention is formed on a surface of an insulating layer 10 formed on an insulating substrate or a silicon substrate, for example. That is, a gate electrode 1 formed of polysilicon having a substantially rectangular section is formed on the surface of insulating layer 10. Impurity for giving conductivity is introduced into gate electrode 1. First dielectric layers 3a having film thickness almost same as that of gate electrode 1 are formed on both sides of gate electrode 1. This first dielectric layer 3a is formed of a TEOS (Tetra Ethyl Ortho Silicate), for example. A second dielectric layer 3b formed of a silicon oxide film, silicon nitride film or the like is formed on the surfaces of the gate electrode 1 and the first dielectric layers 3a. The surface of the second dielectric layer 3b is formed almost flat. Furthermore, a polysilicon layer 8 is formed on the surface of second dielectric layer 3b. Polysilicon layer 8 has a channel region 2 at a region located above the gate electrode, and conductive regions 4 and 5 to serve as source/drain regions are formed on both sides of this channel region 2. The boundary of source/drain regions 4, 5 and channel region 2 may be located above gate electrode 1, and also may be separated from an edge surface of gate electrode 1.

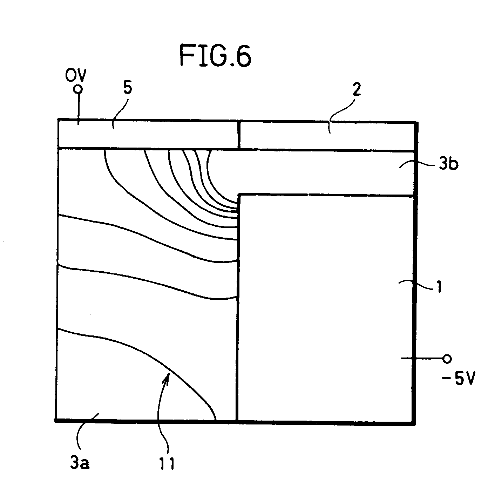

In such a transistor structure as shown in Fig. 1, second dielectric layer 3b provided between gate electrode 1 and channel region 2 is formed having a predetermined film thickness, which is about 250Å, for example. First dielectric layer 3a and second dielectric layer 3b are interposed between gate electrode 1 and conductive regions 4, 5. Fig. 6 is an electric field strength distribution diagram in operation of the thin film transistor shown in Fig. 1. The operational conditions are same as those of Fig. 9 shown in the conventional thin film transistor. That is, -5V is applied to gate electrode 1, 0V is applied to source region 5, and -5V is applied to the drain region. As seen from the figure, in the electric field in dielectric layers 3a, 3b in the vicinity of a corner and a sidewall of gate electrode 1, the gradient of the equal electric field curves 11 is more moderate as compared to the conventional one shown in Fig. 9 to lighten the electric field concentration.

Next, a process of manufacturing the thin film transistor shown in Fig. 1 will be described.

First, as shown in Fig. 2A, a polysilicon layer is deposited to a film thickness of about 1500Å employing the low pressure CVD method on a surface of an insulating layer 10. Impurity ions are then implanted into the polysilicon to give it conductivity. Subsequently, it is patterned into a predetermined shape using the photolithography method and the etching method to form a gate electrode 1.

Next, as shown in Fig. 2B, a TEOS film 3a is deposited to a film thickness of about 10000Å using the low pressure CVD method. The TEOS film shows the flow property when being formed, so that undulation of the foundation such as insulating layer 10 is reduced while the TEOS film is growing, resulting in forming a flat surface of the TEOS film. Such property of a TEOS film is described in "VLSI TECHNOLOGY" Second Edition, by S.M. Sze. McGrow-Hill Book Company, p.p. 235 - 258, for example.

Furthermore, as shown in Fig. 2C, TEOS film 3a is etched back using dry etching such as a reactive ion etching (RIE) to expose the surface of gate electrode 1. By this process, the surfaces of gate electrode 1 and first dielectric layers 3a are formed flat.

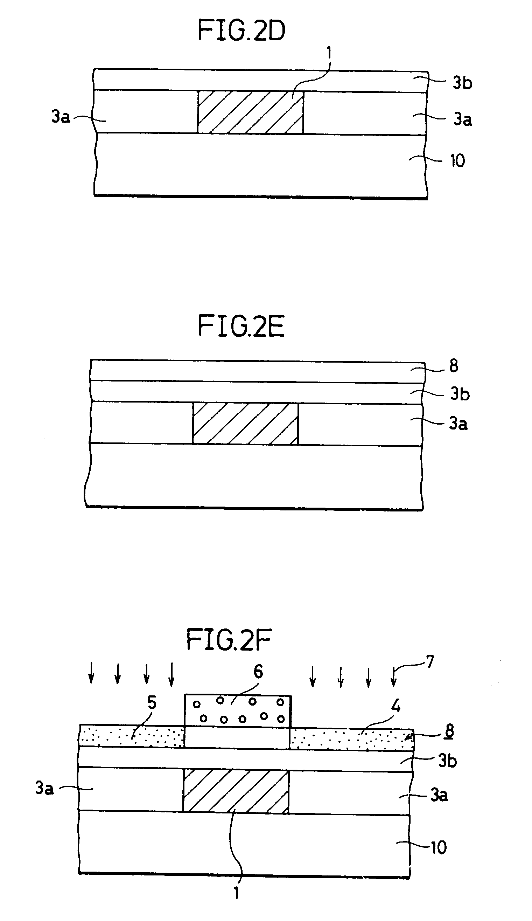

Furthermore, as shown in Fig. 2D, a silicon oxide film (second dielectric layer) 3b is deposited to a film thickness of about 250Å using the low pressure CVD method on the surfaces of gate electrode 1 and first dielectric layers 3a, 3a.

Furthermore, as shown in Fig. 2E, a polysilicon layer 8 is deposited to a film thickness of about 200Å using the low pressure CVD method on the surface of second dielectric layer 3b.

Subsequently, as shown in Fig. 2F, a resist 6 is formed using the photolithography method on the surface of polysilicon layer 8 located above gate electrode 1. Then, using resist 6 as a mask, p type impurity ions, e.g., BF₂ ions 7 are implanted to a dose of about 10¹⁵/cm² into polysilicon layer 8. By this, conductive regions 4, 5 to be source/drain regions are formed in polysilicon layer 8.

In the above embodiment, the dry etching method is employed in etching back of first dielectric layer (TEOS film) 3a, but a wet etching method can be employed.

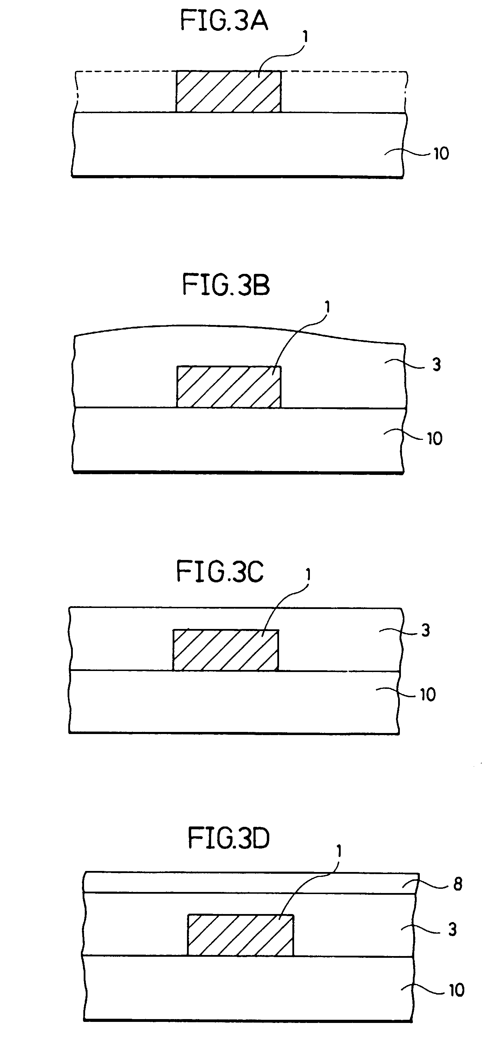

Next, another method of manufacturing a thin film transistor is described. Figs. 3A through 3E are sectional diagrams showing steps for manufacturing a thin film transistor. The steps of Figs. 3A and 3B are the same as those shown in Figs. 2A and 2B of the first embodiment, so that description thereof is not repeated. Next, as shown in Fig. 3C, a TEOS film 3 formed thick on the insulating layer is etched back, in which the etching is finished halfway so that the TEOS film with a predetermined thickness is left on the upper portion of gate electrode 1.

Then, as shown in Fig. 3D, a polysilicon layer 8 with a predetermined film thickness is formed on the surface of dielectric layer 3.

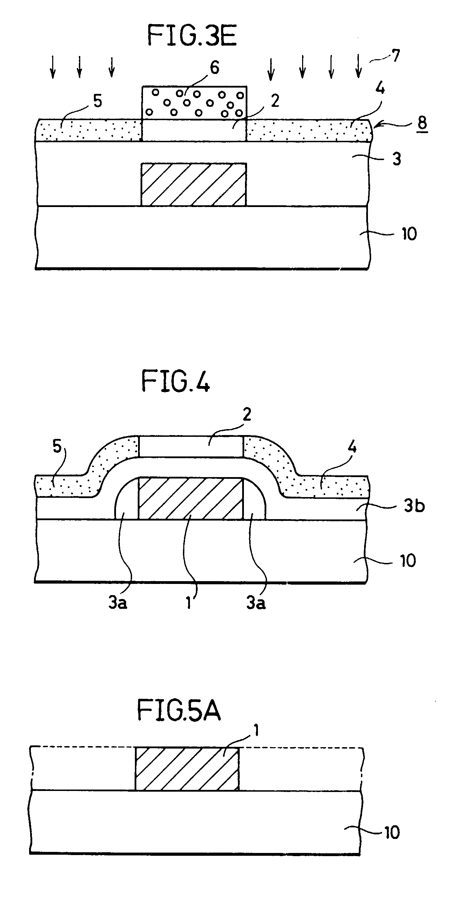

Subsequently, as shown in Fig. 3E, a thin film transistor is formed by the step similar to that of Fig. 2F.

Referring to Fig. 4, another thin film transistor has a two-layered structure as a dielectric layer including first dielectric layers 3a, 3a composed of sidewall insulating layers formed on sidewalls of a gate electrode 1, and a second dielectric layer 3b formed on surfaces of gate electrode 1 and sidewall insulating films 3a, 3a. In such a structure, the electric field concentration produced in regions of a dielectric layer located at corners of gate electrode 1 and side surfaces thereof can be moderated.

Next, the steps of manufacturing the thin film transistor shown in Fig. 4 will be described.

First, as shown in Fig. 5A, a gate electrode 1 is formed by an equivalent step to that described with respect to Fig. 2A.

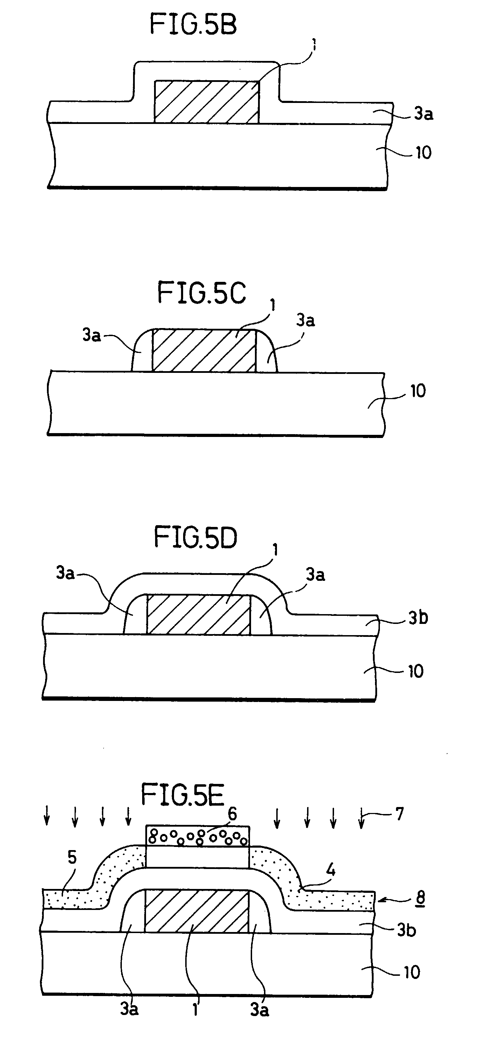

Next, as shown in Fig. 5B, a silicon oxide film 3a is deposited using the low pressure CVD method.

Furthermore, as shown in Fig. 5C, the silicon oxide films 3a, 3a are anisotropically etched. By this anisotropic etching, silicon oxide film 3a is etched and removed uniformly only in the direction of the film thickness. Accordingly, the first dielectric layers 3a, 3a formed of silicon oxide films are formed only on sidewalls of gate electrode 1.

Furthermore, as shown in Fig. 5D, a silicon oxide film 3b is deposited with a predetermined film thickness using the low pressure CVD method all over the surface.

Subsequently, as shown in Fig. 5E, a polysilicon layer 8 is deposited on the surface of the second dielectric layer 3b using the low pressure CVD method. Furthermore, a resist pattern 6 is formed using the photolithography method on the surface of a region located over gate electrode 1 of polysilicon layer 8. Then, using the resist 6 as a mask, p-type impurity ions 7 are implanted into polysilicon layer 8 to form conductive regions 4, 5.

Although, a p-channel transistor has been described above, it is not limited to the same and can be also applied to an n-channel transistor.

Furthermore, although an example in which channel region 2, source/drain region 4 are formed in polysilicon layer 8 has been described above, single crystalline silicon, amorphous silicon, or other semiconductor materials can be employed in place of the polysilicon layer. A single crystalline silicon is formed by the solid phase epitaxial growth method, for example. The amorphous silicon is formed by the CVD method or the spattering method, for example.

An example in which an oxide film is employed as a dielectric layer has been described, but other insulating films such as a nitride film or a multi-layered film thereof may be employed.

As described above, in a thin film transistor in accordance with the present invention, the surface of the dielectric layer covering a gate electrode is made flat, and a polysilicon layer having conductive regions is formed on the surface thereof, so that the electric field concentration is moderated in the vicinity of side portions and angular portions of the gate electrode to increase the life time of the transistor.

## Claims

1. A thin film transistor, comprising:
a gate electrode (1) formed on an insulating layer (10) and having oppsite sidewalls;
a dielectric layer (3a, 3b) formed on said insulating layer (10) and covering upper and side surfaces of said gate electrode (1), said dielectric layer (3b) overlying said gate electrode (1) having a flat surface and a thickness t, and
a semiconductor layer (8) formed on an upper surface of said dielectric layer (3a, 3b),
an interface between said dielectric layer (3a, 3b) and said semiconductor layer (8) lying in a single plane throughout a first region above said gate electrode (1) and a second region extending beyond each said sidewall of said gate electrode (1) by a distance greater than said thickness t of said dielectric layer (3b),
characterized in that
said semiconductor layer (8) has a channel region (2) formed above said gate electrode (1) and has a pair of impurity regions (4, 5) formed
respectively at opposite sides of said channel region (2),
said dielectric layer (3a, 3b) comprises a first insulating layer (3a) formed in contact with said sidewall of said gate electrode (1) and having a film thickness equal to that of said gate electrode (1) and a second insulating layer (3b) formed on the surface of this first insulating layer (3a).

2. The thin film transistor according to claim 1,
wherein said dielectric layer (3a, 3b) comprises a TEOS film (3a).

3. A method of manufacturing a thin film transistor as claimed in claim 1,
comprising the steps of:
a) forming a gate electrode (1) on a surface of an insulating layer (10);
b) forming a dielectric layer (3a, 3b) covering an upper surface and side surfaces of said gate electrode (1) and having a flat surface;
c) forming a semiconductor layer (8) on a surface of said dielectric layer (3); and
d) forming a pair of impurity regions (4, 5) by forming a mask layer (6) with a predetermined shape on a surface of said semiconductor layer (8) and ion-implanting impurity (7) into said semiconductor layer (8) using said mask layer (6),
wherein the step of forming said dielectric layer (3a, 3b) includes the steps of:
b1) forming a gate insulating film formed of a TEOS film on surfaces of said insulating layer (10) and said gate electrode (1), and
b2) planarizing the surface of said TEOS film by etching back said TEOS film.

## Patentansprüche

1. Dünnfilm-Transistor mit:
einer Gateelektrode (1), die auf einer Isolierschicht (10) gebildet ist und gegenüberliegende Seitenwände aufweist;
einer dielektrischen Schicht (3a, 3b), die auf der Isolierschicht (10) gebildet ist und die obere Oberfläche und die Seitenoberflächen der Gateelektrode (1) bedeckt, wobei die dielektrische Schicht (3b), die über der Gateelektrode (1) liegt, eine flache Oberfläche und eine Dicke (t) aufweist; und
einer Halbleiterschicht (8), die auf der oberen Oberfläche der dielektrischen Schicht (3a, 3b) gebildet ist;
wobei eine Trennfläche zwischen der dielektrischen Schicht (3a, 3b) und der Halbleiterschicht (8) in einer einzigen Ebene durch einen ersten Bereich oberhalb der Gateelektrode (1) und durch einen zweiten Bereich, der sich über jeder Seitenwand der Gateelektrode (1) um einen Abstand größer als die Dicke (d) der dielektrischen Schicht (3b) nach außen erstreckt, liegt;
dadurch gekennzeichnet, daß
die Halbleiterschicht (8) einen Kanalbereich (2), der oberhalb der Gateelektrode (1) gebildet ist, aufweist und ein Paar von dotierten Bereichen (4, 5), die auf den entsprechenden gegenüberliegenden Seiten des Kanalbereiches (2) gebildet sind, aufweist,
daß die dielektrische Schicht (3a, 3b) eine erste Isolierschicht (3a), die in Kontakt mit der Seitenwand der Gateelektrode (1) gebildet ist und eine Schichtdicke gleich der der Gateelektrode (1) aufweist, und eine zweite Isolierschicht (3b), die auf der Oberfläche dieser ersten Isolierschicht (3a) gebildet ist, aufweist.

2. Dünnfilm-Transistor nach Anspruch 1,
bei dem die dielektrische Schicht (3a, 3b) einen TEOS-Film (3a) aufweist.

3. Verfahren zum Herstellen eines Dünnfilm-Transistors, wie er in Anspruch 1 beansprucht ist,
mit den Schritten:
a) Bilden einer Gateelektrode (1) auf einer Oberfläche einer Isolierschicht (10);
b) Bilden einer dielektrischen Schicht (3a, 3b), die eine obere Oberfläche und Seitenoberflächen der Gateelektrode (1) bedeckt und eine flache Oberfläche aufweist;
c) Bilden einer Halbleiterschicht (8) auf einer Oberfläche der dielektrischen Schicht (3); und
d) Bilden eines Paares von dotierten Bereichen (4, 5) durch Bilden einer Maskenschicht (6) mit einer vorbestimmten Form auf einer Oberfläche der Halbleiterschicht (8) und Ionenimplantieren von Dotierstoff (7) in die Halbleiterschicht (8) unter Benutzung der Maskenschicht (6);
wobei der Schritt des Bildens der dielektrischen Schicht (3a, 3b) die Schritte aufweist:
bl) Bilden eines Gateisolierfilmes, der aus einem TEOS-Film gebildet wird, auf den Oberflächen der Isolierschicht (10) und der Gateelektrode (1) und
b2) Planarisieren der Oberfläche der TEOS-Filmes durch Zurückätzen des TEOS-Filmes.

## Revendications

1. Un transistor à couches minces, comprenant :
une électrode de grille (1) formée sur une couche isolante (10) et ayant des parois latérales opposées;
une couche diélectrique (3a, 3b) formée sur la couche isolante (10) et recouvrant des surfaces supérieure et latérale de l'électrode de grille (1), cette couche diélectrique (3b) recouvrant l'électrode de grille (1) et ayant une surface plate et une épaisseur t, et
une couche de semiconducteur (8) formée sur une surface supérieure de la couche diélectrique (3a, 3b),
une interface entre la couche diélectrique (3a, 3b) et la couche de semiconducteur (8) s'étendant dans un seul plan sur la totalité d'une première région située au-dessus de l'électrode de grille (1) et d'une seconde région s'étendant au-delà de chaque paroi latérale de l'électrode de grille (1), sur une distance supérieure à l'épaisseur t de la couche diélectrique (3b),
caractérisé en ce que
la couche de semiconducteur (8) comporte une région de canal (2) formée au-dessus de l'électrode de grille (1), et elle comporte une paire de régions d'impureté (4, 5) qui sont respectivement formées sur des côtés opposés de la région de canal (2), et
la couche diélectrique (3a, 3b) comprend une première couche isolante (3a) formée en contact avec la paroi latérale de l'électrode de grille (1) et ayant une épaisseur de pellicule égale à celle de l'électrode de grille (1), et une seconde couche isolante (3b) formée sur la surface de cette première couche isolante (3a).

2. Le transistor à couches minces selon la revendication 1,
dans lequel la couche diélectrique (3a, 3b) comprend une pellicule de TEOS (3a).

3. Un procédé de fabrication d'un transistor à couches minces selon la revendication 1,
comprenant les étapes suivantes :
a) on forme une électrode de grille (1) sur une surface d'une couche isolante (10);
b) on forme une couche diélectrique (3a, 3b) recouvrant une surface supérieure et des surfaces latérales de l'électrode de grille (1) et ayant une surface plate;
c) on forme une couche de semiconducteur (8) sur une surface de la couche diélectrique (3); et
d) on forme une paire de régions d'impureté (4, 5) en formant une couche de masque (6) avec une forme prédéterminée sur une surface de la couche de semiconducteur (8) et on introduit une impureté (7), par implantation ionique, dans la couche de semiconducteur (8), en utilisant la couche de masque (6),
dans lequel l'étape de formation de la couche diélectrique (3a, 3b) comprend les étapes suivantes :
b1) on forme une pellicule isolante de grille, constituée par une pellicule de TEOS, sur des surfaces de la couche isolante (10) et de l'électrode de grille (1), et
b2) on aplanit la surface de la pellicule de TEOS par l'application d'une opération d'attaque réduisant l'épaisseur de cette pellicule de TEOS.
